# FASCICULE DE BREVET EUROPEEN

(11) **EP 0 851 017 B1**
(45) Date de publication et mention de la délivrance du brevet: **29.10.2003**
(21) Numéro de dépôt: 97403093.4
(22) Date de dépôt: 19.12.1997
(51) Int. Cl.: C09K 11/06, C08F 8/00, H01L 51/20

(54) **Matériaux électroluminescents comprenant des polymères électroluminescents dérivés du polystyrène**
Elektrolumineszente Materialen mit Polymere von elektrolumeszenten Polystyrolderivaten
Electroluminescent materials with polymers of electroluminescent polystyrene derivates

(30) Priorité: 24.12.1996 FR 9615935
(43) Date de publication de la demande: 01.07.1998
(73) Titulaire: Thales, 75008 Paris (FR)
(72) Inventeur: Le Barny, Pierre, 94117 Arcueil Cedex (FR); Soyer, Françoise, 94117 Arcueil Cedex (FR); Facoetti, Hugues, 94117 Arcueil Cedex (FR)

(56) Documents cités:
- EP-A- 0 712 171
- EP-A- 0 735 055
- FR-A- 2 736 061

## Description

L'invention concerne des matériaux électroluminescents comprenant des polymères électroluminescents pouvant notamment être utilisés en visualisation.

Actuellement le marché des écrans de visualisation est dominé par les tubes cathodiques. Mais ceux-ci, malgré leurs nombreux avantages, souffrent d'un certain nombre de limitations comme leur encombrement, leur poids et la difficulté d'obtenir des écrans courbes de forme complexe et de grande dimension.

L'électroluminescence basée sur l'utilisation de polymères apparaît aujourd'hui comme étant la technologie susceptible de pallier les insuffisances des tubes cathodiques. En effet :
. le principe même de fonctionnement des écrans électroluminescents requiert l'emploi du matériau en film très mince (< 1 µm) et donc conduit à des afficheurs plats et légers ;
. le dépôt du polymère électroluminescent par centrifugation présente les avantages d'être peu coûteux, de conduire à des écrans courbes (lorsqu'un substrat souple est utilisé) et d'accéder à des écrans de grandes dimensions ;
. enfin, le polymère est susceptible d'être gravé, ce qui ouvre de nombreuses perspectives dans la réalisation d'écrans complexes.

Par ailleurs, comparés aux écrans à cristaux liquides, les écrans électroluminescents offrent un meilleur angle de vue, une mise en oeuvre plus simple (pas de couche d'alignement) et ne requièrent pas de rétroéclairage.

Les polymères conjugués comme le PPV et le MEH-PPV sont les plus étudiés.

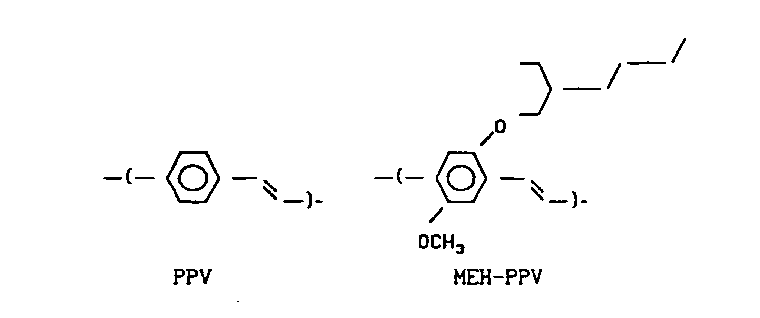

Ces polymères émettent respectivement dans le jaune-vert et, dans l'orange avec un bon rendement quantique et une durée de vie de plusieurs milliers d'heures. Mais ils posent plusieurs problèmes :
- le PPV est insoluble, ce qui impose de passer par un précurseur soluble pour déposer un film mince et de pyrolyser le film a une température comprise entre 200 et 280°C sous vide pour obtenir une couche mince de PPV ;
- le MEH-PPV est difficilement soluble dans les solvants organiques usuels et conduit à la formation de gels ce qui complique sa mise en oeuvre ;
- le PPV et le MEH-PPV en film mince subissent une photo-oxydation rapide lorsqu'ils sont exposés à l'oxygène de l'air en présence de lumière naturelle, ce qui alourdit leur future industrialisation ;
- aucune modification chimique simple du PPV permet de conduire à un matériau émettant dans le bleu ou le rouge.

L'émission dans le bleu est obtenue en utilisant des polymères (1) en échelle du type : 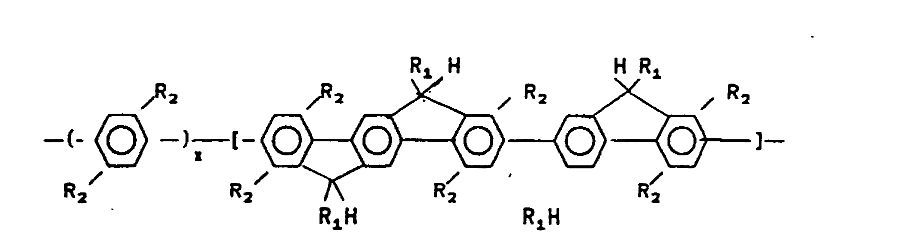
(1) J. HUBERT, K. MÜLLEN, J. SALBECK, H. SCHENK, U. SCHERF, T. STEHLIN and R. STERN Acta. Polym. 45 244 (1994)
(2) F. CACIALLI, X-C LI, R.H. FRIEND, S.C. MORATTI, A.B. HOLMES, Synthetic Metals 75 161-168 (1995)
mais leur synthèse est longue et délicate.

Enfin il n'existe pas de polymère émettant de manière efficace dans le rouge.

Par ailleurs, tous les polymères conjugués selon la chaine principale présentent l'inconvénient d'avoir leur longueur d'onde d'émission liée au degré de polymérisation et aux "accidents" qui peuvent survenir dans l'enchaînement des unités monomères. C'est la raison pour laquelle la demanderesse a déjà proposé d'introduire l'entité émettrice dans la chaîne latérale des polymères (demande de brevet 2 736 061) ce qui a pour avantage d'une part d'élargir le choix de l'entité émettrice et donc d'accéder à toutes les longueurs d'onde du visible et d'autre part d'avoir un matériau dont la longueur d'onde d'émission est indépendante du degré de polymérisation du polymère.

Il s'agit de matériaux comprenant des polymères dérivés des polyacrylates et polyméthacrylate. Mais il a été prouvé expérimentalement (2) que les groupes méthacrylates ne sont pas très stables lorsqu'ils sont soumis à des courants et des champs électriques importants.

Dans ce contexte, l'invention a pour objet une nouvelle famille de matériaux électroluminescents comprenant des polymères électroluminescents à chaîne latérale conçue pour être stable dans le temps et performante au niveau des propriétés d'électroluminescence. Ces matériaux comprennent des polymères répondant à la formule chimique suivante : 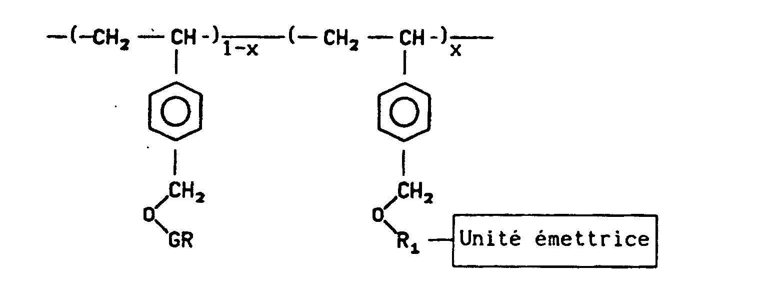 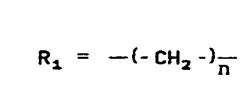 avec 2 ≤ n ≤ 10

L'unité émettrice peut être de type : 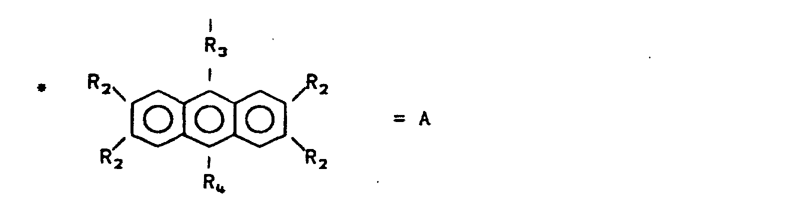 avec R₂ : ―O―C_{q}H_{2q+1}; ―OOC―C_{q}H_{2q+1} avec 1 ≤ q ≤ 20 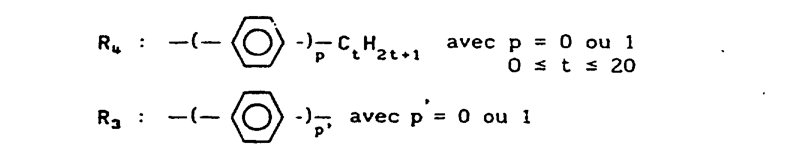 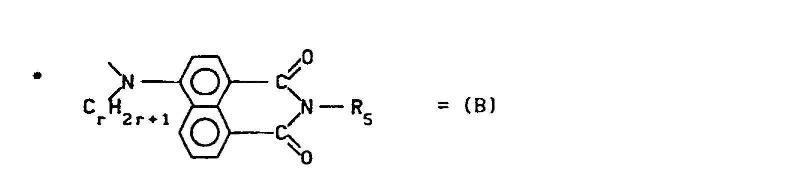 avec 1 ≤ r ≤ 10 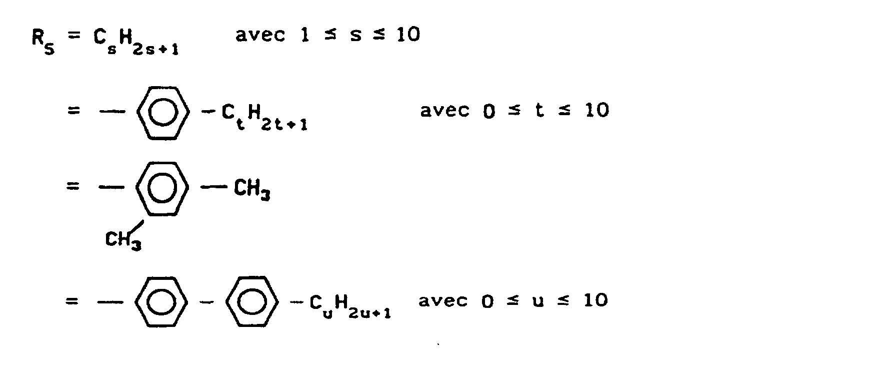 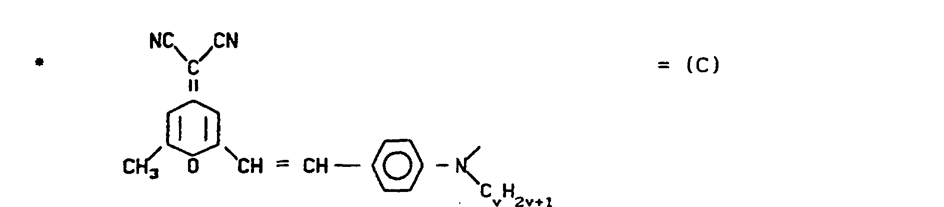 avec 1 ≤ v ≤ 10

GR est un groupement réticulable de type 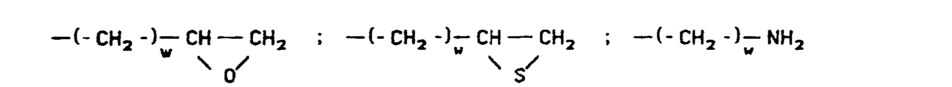 avec 2 ≤ w ≤ 10

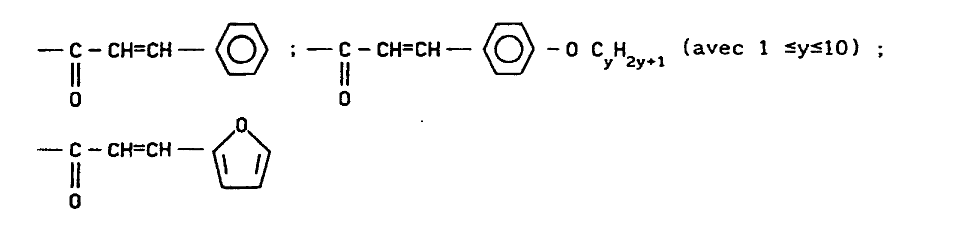

Le matériau électroluminescent proposé dans l'invention peut comprendre en plus du polymère cité ci-dessus, des molécules dont le spectre d'absorption recouvre au moins partiellement le spectre d'électroluminescence selon l'invention et dont le spectre d'émission est situé dans des longueurs d'ondes supérieures.

Pour émettre dans le vert, le matériau électroluminescent selon l'invention peut avantageusement comprendre des molécules de type :

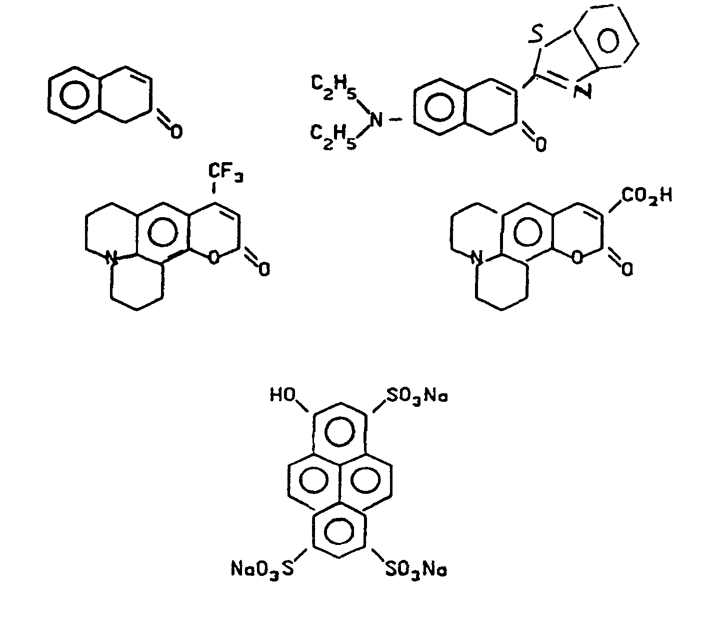

Pour émettre dans le rouge, le matériau électroluminescent selon l'invention peut avantageusement comprendre des molécules de type :

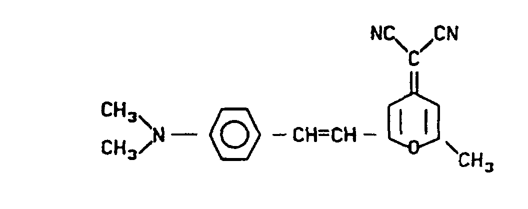

L'invention a aussi pour objet une diode électroluminescente comprenant un substrat recouvert d'une anode, une couche C₁ assurant le transport de trous, une couche C₂ comprenant un matériau électroluminescent selon l'invention, une couche C₃ assurant le transport d'électrons et une cathode K, le substrat peut être en verre ou en polymère, la couche C₁ peut être du PVK ou un polymère dérivé du TDD de formule

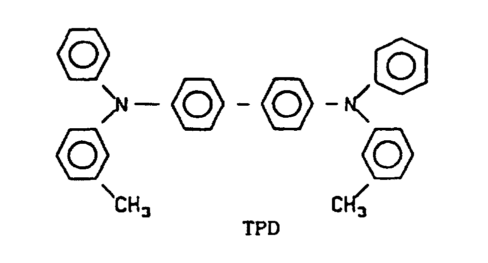

L'anode peut être de l'ITO ou un polymère conducteur comme la polyaniline.

La couche C₃ peut être un polymère dérivé de

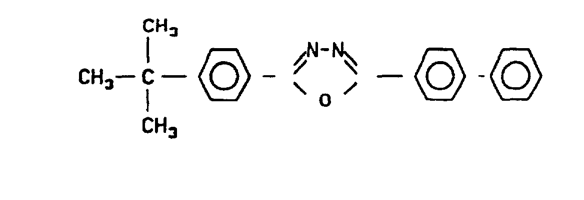

La cathode peut être Al, Ca ou Sm.

L'invention a aussi pour objet un procédé de fabrication d'un matériau selon l'invention comportant un polymère dans lequel :
x = 1 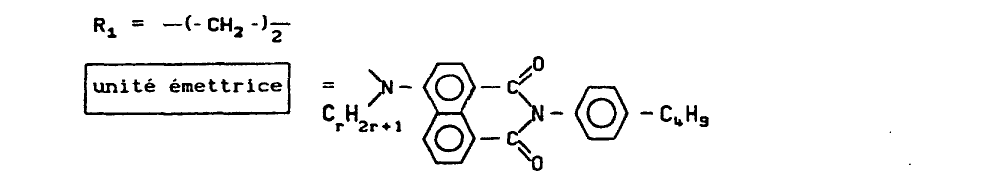 avec r = 1

Ce procédé comprend :
- La synthèse du poly[N(4 butylphényl) - 4 - (N-4 vinyl benzyloxyéthyl, N méthyl amino) naphtalimide comportant les étapes suivantes :
- La synthèse du 4-(N-2 hydroxyléthyl, N méthylamino) N (4 butyl phényl) naphtalimide ;
- La synthèse du monomère le N (4 butylphényl) -4- (N-4 vinyl benzyloxyéthyl, N méthyl amino) naphtalimide par réaction du 4-(N - 2 hydroxyl éthyl, N méthylamino) N (4 butyl phényl) naphtalimide en présence de NaH, d'éther de pétrole 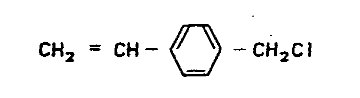 et de diméthyl formamide (DMF) ;
- La polymérisation en présence de toluène et d'azobisisobutyronitrite (AIBN) du monomère.

L'invention sera mieux comprise et d'autres avantages apparaîtront à la lecture de la description qui va suivre donnée à titre non limitatif et grâce aux figures annexées parmi lesquelles :
- la figure 1 illustre les étapes d'un procédé de synthèse d'un polymère utilisé dans un matériau selon l'invention ;

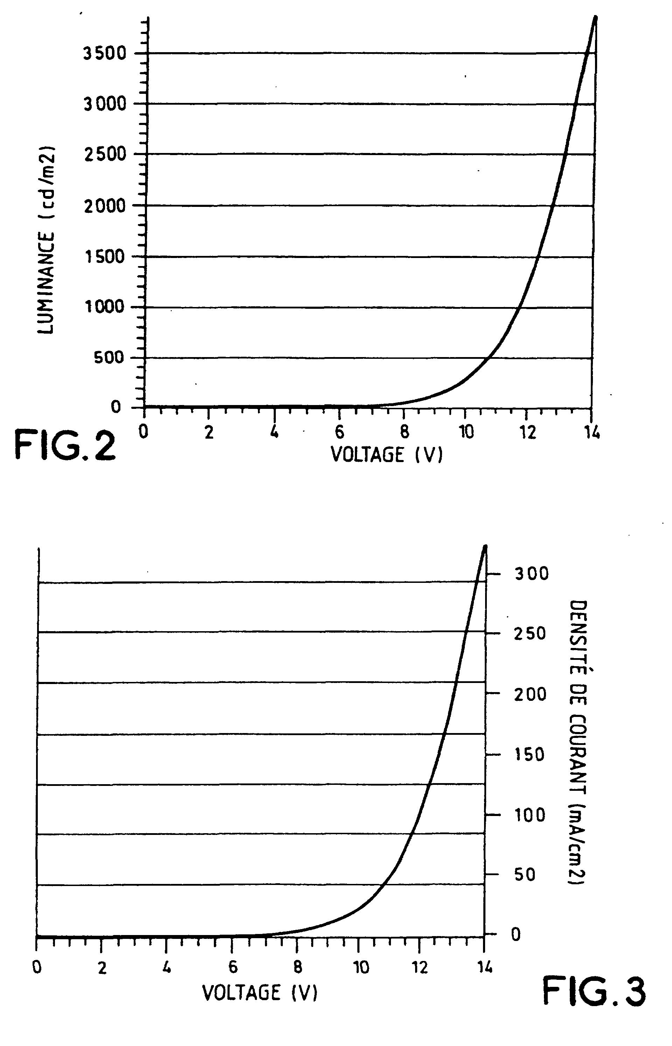

- la figure 2 illustre l'évolution de la luminance d'un exemple de diode électroluminescente selon l'invention, en fonction de la tension appliquée à cette diode ;
- la figure 3 illustre l'évolution de la densité de courant détectée au niveau de l'exemple de diode électroluminescente selon l'invention dont la luminance est illustrée en figure 2, en fonction de la tension appliquée à cette diode.

L'intérêt des polymères réticulables selon l'invention est double :
- d'une part il rend possible le dépôt par centrifugation de la couche injectrice d'électrons (ou bloqueuse de trous) sans redissolution de la couche émettrice ;
- d'autre part il évite la cristallisation des molécules dans le temps lorsque celles-ci sont ajoutées au polymère.

Lorsque le groupe réticulable est de type : 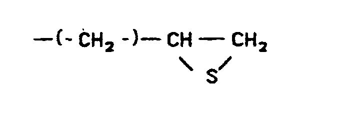 la réticulation est assurée par simple chauffage ou par ajout dans la solution d'enduction de molécules possédant plusieurs fonctions amine aliphatique comme par exemple : 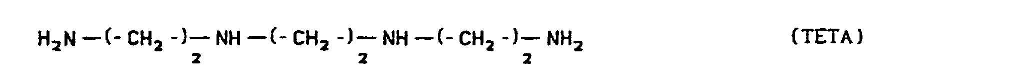 puis chauffage.

Lorsque le groupe réticulable est de type :

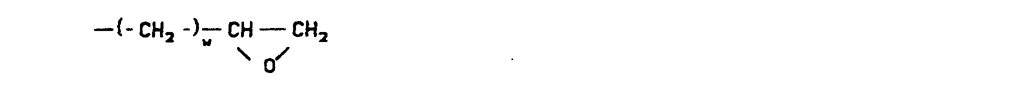

la réticulation est obtenue grâce à l'ajout dans la solution d'enduction de molécules possédant plusieurs fonctions amine aliphatique comme : 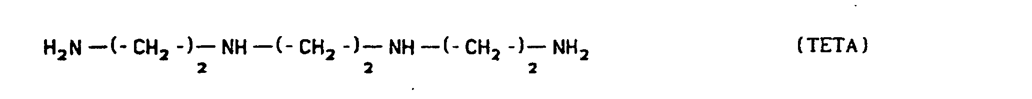 puis chauffage

Lorsque le groupe réticulable est de type : 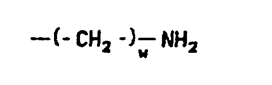 la réticulation est réalisée grâce à l'ajout dans la solution d'enduction de molécules possédant plusieurs fonctions époxy comme :

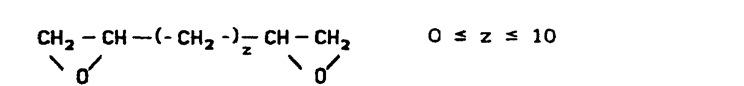

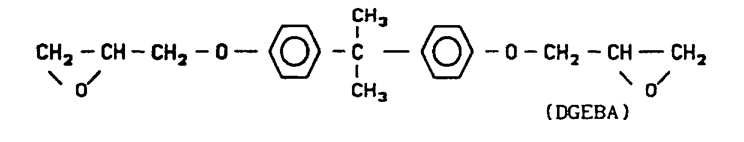

Enfin lorsque le groupe réticulable est de type : 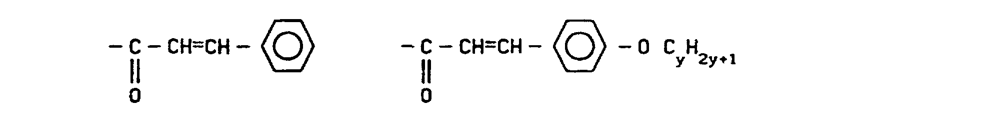 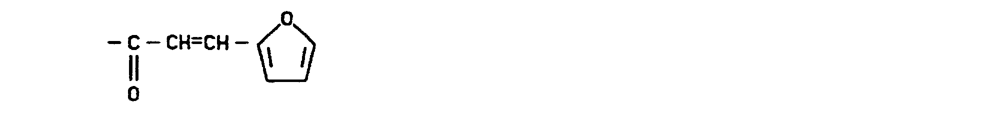 avec 0 ≤ y ≤ 1
la réticulation se fait de manière photochimique en utilisant des lampes UV fluorescentes.

Nous allons décrire un exemple de procédé de synthèse conduisant à un polymère particulier utilisé dans le matériau selon l'invention.

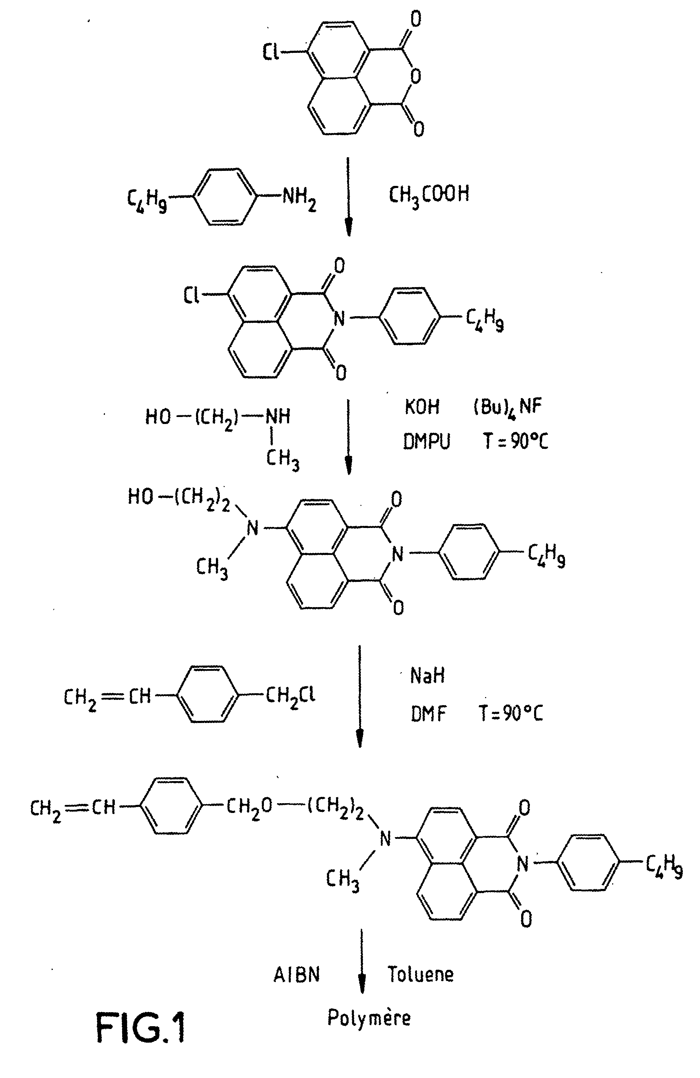

Il s'agit de l'homopolymère suivant : le poly[N(4 butyl phényl) - 4 - (N - 4 vinyl benzyloxyéthyl, N méthyl amino) naphtalimide dont le schéma de synthèse est présenté figure 1.

La synthèse du 4 - (N - 2 hydroxyl éthyl, N méthylamino) N (4 butyl phényl) naphtalimide est illustrée en début de figure 1.

Synthèse du N(4 butyl phényl) - 4 -(N - 4 vinylbenzyloxy éthyl, N méthyl amino) naphtalimide.

Dans un tricol, équipé d'un septum permettant l'introduction d'une seringue de manière hermétique, de 100 ml muni d'un agitateur magnétique on pèse 0,2 g d'hydrure de sodium en suspension dans l'huile (60 % de NaH en poids). Le tricol est rempli d'environ 20 ml d'éther de pétrole.

Pendant toute la réaction, on maintient un courant d'argon.

On agite NaH avec l'éther de pétrole, puis on laisse décanter et on aspire le liquide au moyen d'une seringue qui traverse le septum.

Cette opération est répétée 2 fois et a pour but d'éliminer l'huile qui entoure NaH.

L'éther de pétrole est finalement remplacé par 30 ml de DMF distillé.

On dissout 1 g (2,487 mmole) dans le minimum de DMF et on introduit la solution ainsi formée au moyen de la seringue.

On agite 30 mn à T ambiante.

On ajoute ensuite de la même manière, 0,379 g (2,48 mmole) de 4 chlorométhylstyrène.

On chauffe 4 h à 90°C.

On laisse ensuite revenir le milieu réactionnel à T ambiante et on le verse dans l'eau.

On extrait au dichlorométhane.

La phase organique est évaporée à sec ce qui conduit à une solution du produit brut dans le DMF.

On ajoute de l'eau à la solution précédente. La phase aqueuse est éliminée par surverse.

On recommence l'opération 2 fois afin d'éliminer le DMF.

Le produit brut débarrassé de DMF est purifié par 2 chromatographies sur SiO₂ éluant dichlorométhane suivies d'une chromatographie sur SiO₂ éluant benzène.

Le brut de chromatographie est purifié par cristallisation dans le méthanol.
Rendement 23,3 %
Point de fusion 133,8°C

### Synthèse de l'homopolymère

Dans une ampoule préscellée munie d'une agitation magnétique, on introduit 0,29 g de monomère (0,559 mmole) 1,53 mg d'AIBN et 4 ml de toluène distillé.

La solution est dégazée 3 fois et l'ampoule est scellée sous vide.

Le mélange réactionnel est chauffé à 70°C pendant 24 h.

Le polymère est précipité une fois dans le méthanol et une fois dans l'éthanol.
Tg = 111°C

### Exemple de réalisation de diode électroluminescente

Sur un substrat de verre recouvert d'ITO, on dépose à la centrifugeuse une solution de PVK (10 gl⁻¹) à 3 000 t/mn pendant 30 s. Solvant 1,1,2 trichloroéthane.

Puis on réalise une solution d'homopolymère dans le 11,2 trichloroéthane (20 gl⁻¹) et on la dépose sur le film de PVK par centrifugation (3 000 t/mn).

Enfin on dépose une contre-électrode de calcium.

La diode ainsi formée est soumise à une tension croissante.

On obtient les courbes 2 et 3.

La luminance maximum est 3 800 Cd/m² pour V = 14 V et j = 322 mA cm⁻².

100 Cd/m² sont obtenus pour V = 9 V et j = 10,8 mA cm⁻².

## Revendications

1. Matériau électroluminescent comprenant un polymère électroluminescent à chaînes latérales **caractérisé en ce que** ledit polymère électroluminescent répond à la formule chimique suivante : 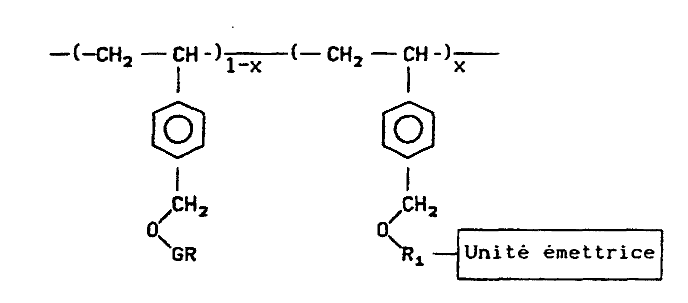 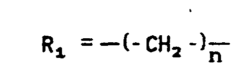 avec 2 ≤ n ≤ 10
L'unité émettrice étant de type 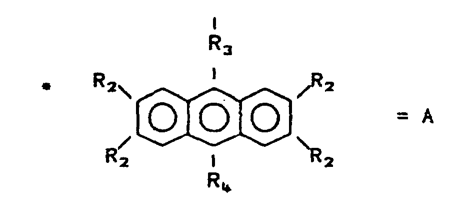 avec R₂ : ―O- C_{q}H_{2q+1} ; ―OOC- C_{q}H_{2q+1} avec 1 ≤ q ≤ 20 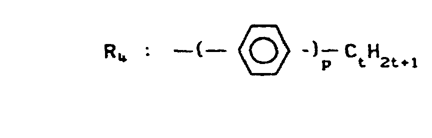 avec p = 0 ou 1 0 ≤ t ≤ 20 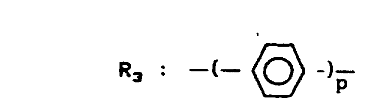 avec p = 0 ou 1
*ou 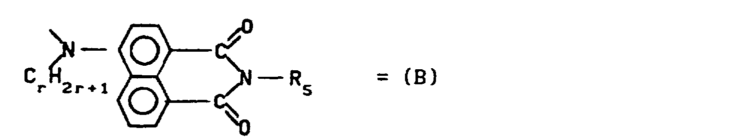 avec 1 ≤ r ≤ 10
R₅ : CₛH₂ₛ₊₁ avec 1 ≤ s ≤ 10
ou 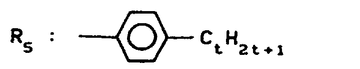 avec 0 ≤ t ≤ 10 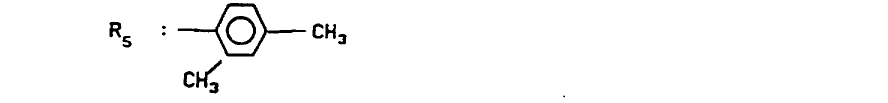 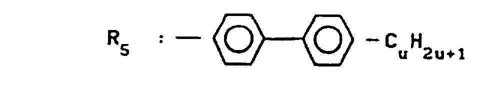 avec 0 ≤ u ≤ 10
*ou 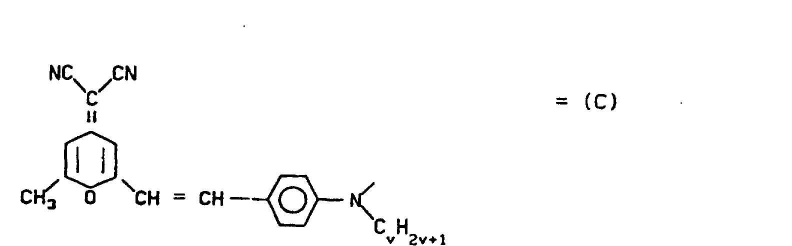 avec 1 ≤ v ≤ 10
GR est un groupement réticulable de type 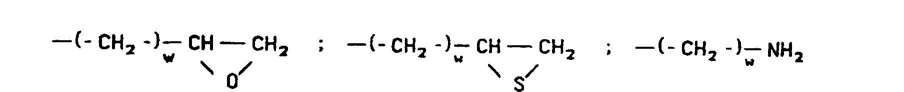 avec 2 ≤ w ≤ 10 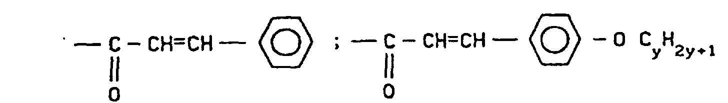 (avec 1 ≤y≤10) ; 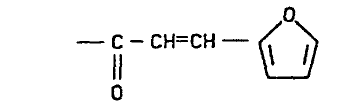 et **caractérisé en ce qu'**il comprend en outre des molécules dont le spectre d'absorption recouvre au moins partiellement le spectre d'électroluminescence du polymère électroluminescent et dont le spectre d'émission est situé dans des longueurs d'ondes supérieures audit spectre d'électroluminescence.

2. Matériau électroluminescent selon la revendication 1, émettant dans le vert, **caractérisé en ce que** les molécules sont de type :

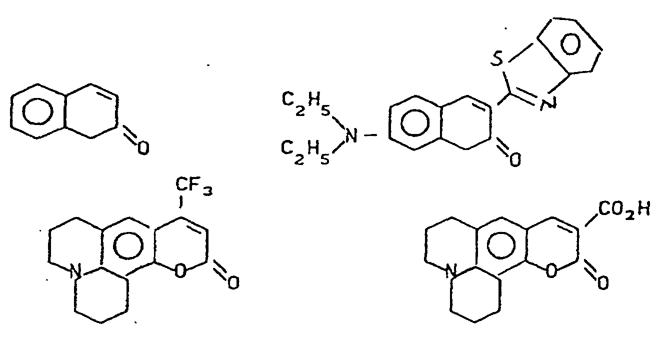

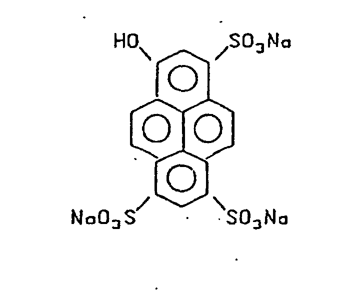

3. Matériau électroluminescent selon la revendication 1, émettant dans le rouge, **caractérisé en ce que** les molécules sont de type :

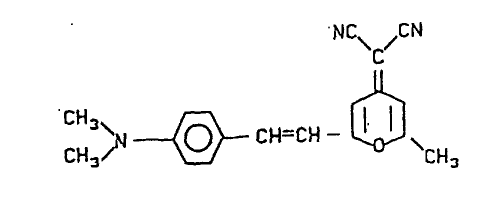

4. Diode électroluminescente comprenant un busbstrat recouvert d'une anode, une couche (C₁) assurant le transport de trous, une couche (C₂) comprenant un matériau électroluminescent selon l'une des revendications 1 à 3, une couche (C₃) assurant le transport d'électrons et une cathode.

5. Diode électroluminescente selon la revendication 4,
**caractérisée en ce que** le matériau de la couche (C₁) est de type polyvinylcarbazole ou de type polymère dérivé de

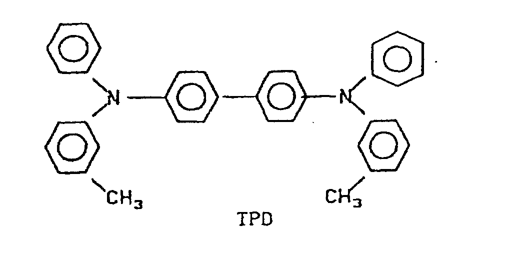

6. Diode électroluminescente selon l'une des revendications 4 ou 5, **caractérisée en ce que** le matériau de la couche (C₃) est de type

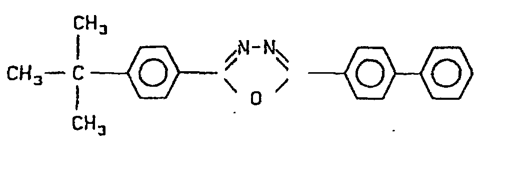

7. Procédé de fabrication d'un matériau électroluminescent selon la revendication 1, **caractérisé en ce qu'**il comprend la synthèse du poly [N(4 butylphényl) - 4 - (N-4 vinyl benzyloxyéthyl, N méthyl amino)] naphtalimide comportant les étapes suivantes :
- la synthèse du 4-(N-2 hydroxyléthyl, N méthylamino) N (4 butyl phényl) naphtalimide ;
- la synthèse du monomère le N (4 butylphényl) -4- vinyl benzyloxyloxyéthyl, N méthyl amino) naphtalimide par réaction du 4-(N - 2 hydroxyl éthyl, N méthylamino) N (4 butyl phényl) naphtalimide en présence de NaH, d'éther de pétrole 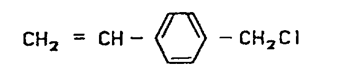 et de dimétyhyl formamide (DMF);
- la polymérisation en présence de toluène et d'azobisisobutyronitrite (AIBN) du monomère.

## Patentansprüche

1. Elektrolumineszierendes Material mit einem elektrolumineszierenden Seitenkettenpolymer, **dadurch gekennzeichnet, daß** das elektrolumineszierende Polymer der folgenden chemischen Formel entspricht: 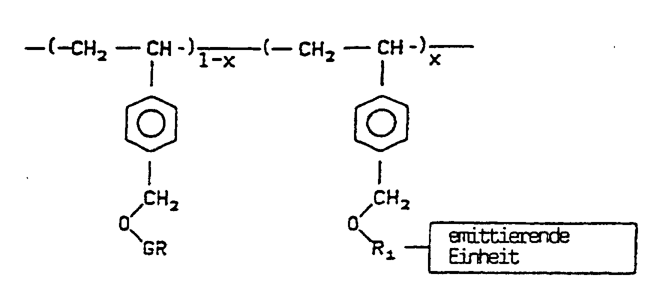 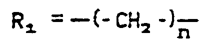 mit 2 ≤ n ≤ 10
wobei die emittierende Einheit vom Typ 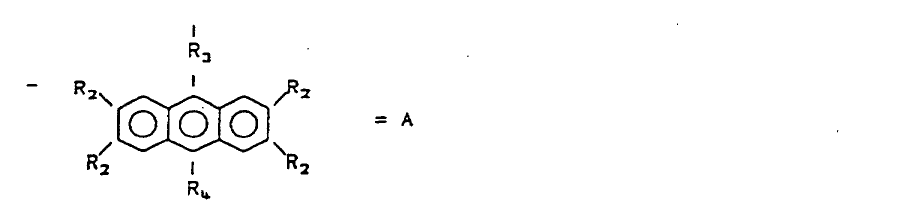 ist, mit · R₂ : ―O―C_{q}H_{2q+1} ; ―OOC―C_{q}H_{2q+1} mit 1 ≤ q ≤ 20 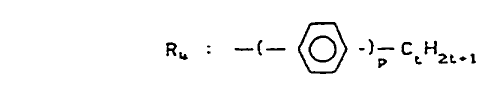 mit p = 0 oder 1
0 ≤ t ≤ 20 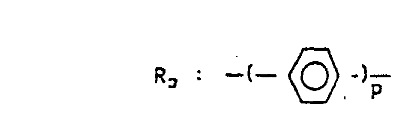 mit *p* =0 oder 1
- oder 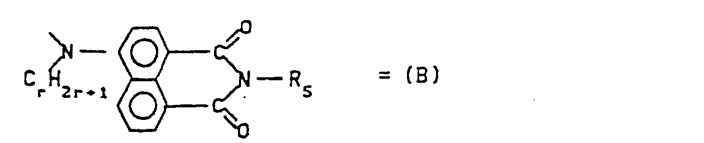 mit 1 ≤ r ≤ 10
R_{S} : CₛH₂ₛ₊₁ mit 1 ≤ s ≤ 10
oder 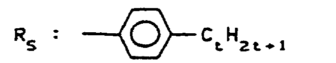 mit 0 ≤ t ≤ 10 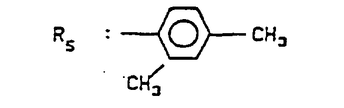 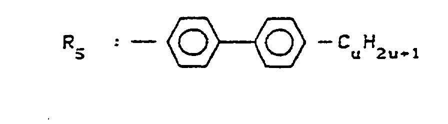 mit 0 ≤ u ≤ 10
- oder 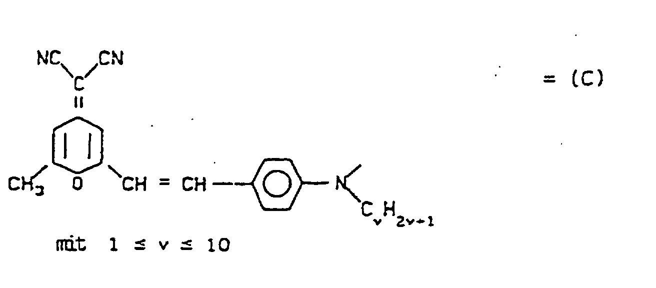
wobei GR eine vernetzbare Gruppe des Typs 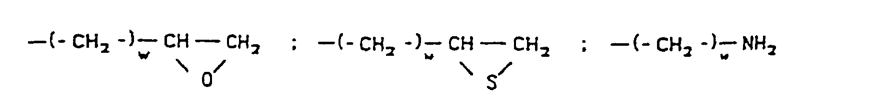 ist, mit 2 ≤ w ≤ 10 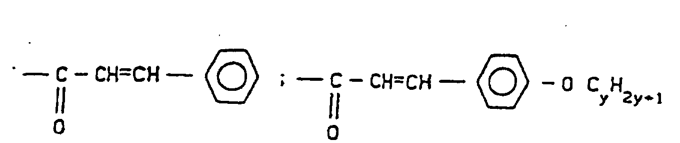 (mit 1 ≤y≤10) : 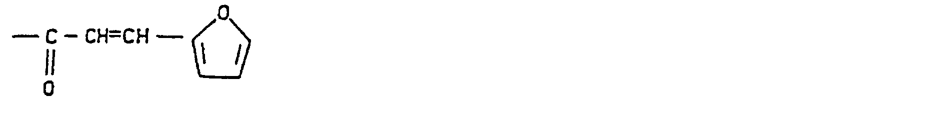 und welches **dadurch gekennzeichnet ist, daß** es weitere Moleküle umfaßt, deren Absorptionsspektrum wenigstens teilweise das Elektrolumineszenzspektrum des elektrolumineszierenden Polymers abdeckt und deren Emissionsspektrum in den Wellenlängen oberhalb des Elektrolumineszenzspektrums liegt.

2. Elektrolumineszierendes Material nach Anspruch 1 mit grüner Emission, **dadurch gekennzeichnet, daß** die Moleküle vom folgenden Typ sind:

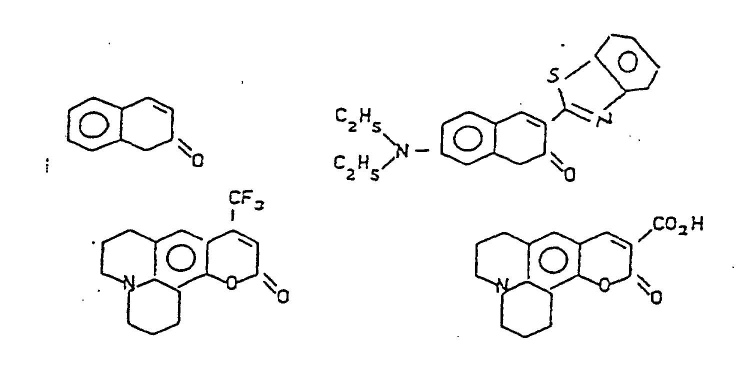

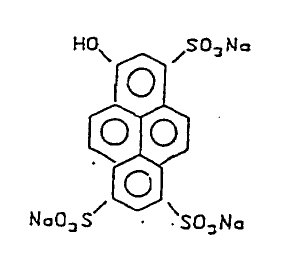

3. Elektrolumineszierendes Material nach Anspruch 1, mit roter Emission, **dadurch gekennzeichnet, daß** die Moleküle vom folgenden Typ sind:

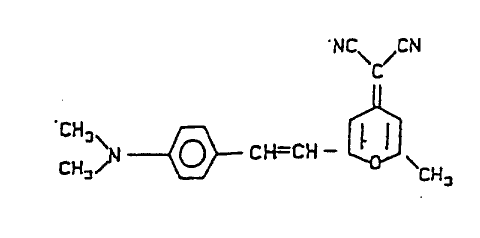

4. Leuchtdiode mit einem von einer Anode bedeckten Substrat, einem den Transport von Löchern gewährleistenden Überzug (C₁), einem Überzug (C₂) mit einem elektrolumineszierenden Material nach einem der Ansprüche 1 bis 3, einem den Elektronentransport gewährleistenden Überzug (C₃) und einer Katode.

5. Leuchtdiode nach Anspruch 4, **dadurch gekennzeichnet, daß** das Material des Überzugs (C₁) vom Typ eines Polyvinylcarbazols oder vom Typ eines von 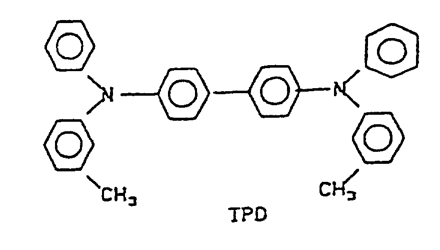 abgeleiteten Polymers ist.

6. Leuchtdiode nach einem der Ansprüche 4 oder 5, **dadurch gekennzeichnet, daß** das Material des Überzugs (C₃) vom folgenden Typ ist:

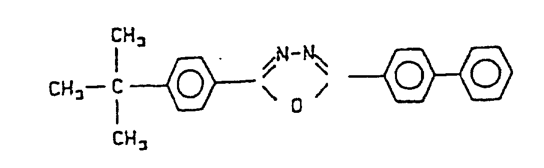

7. Verfahren zur Herstellung eines elektrolumineszierenden Materials gemäß Anspruch 1, **dadurch gekennzeichnet, daß** das Verfahren die Synthese von Poly[N-(4-butylphenyl)-4-(N-4-vinylbenzyloxyethyl, N-methylamino)]-naphtalimid mit den folgenden Schritten umfaßt:
- die Synthese von 4-(N-2 Hydroxyethyl, N-methylamino)-N-(4-butylphenyl)-naphtalimid;
- die Synthese des Monomers N-(4-Butylphenyl)-4-(N-4-vinylbenzyloxyethyl, N-methylamino)-naphtalimid durch Umsetzung von 4-(N-2-Hydroxylethyl, N-methylamino)-N-(4-butylphenyl)-naphtalimid in Gegenwart von NaH, Petrolether, 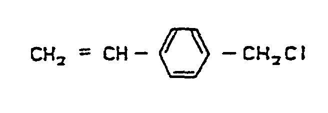 und von Dimethylformamid (DMF);
- die Polymerisation des Monomers in Gegenwart von Toluol und Azobisisobutyronitril (AIBN).

## Claims

1. Electroluminescent material comprising an electroluminescent polymer possessing side chains, **characterized in that** the said electroluminescent polymer corresponds to the following chemical formula: 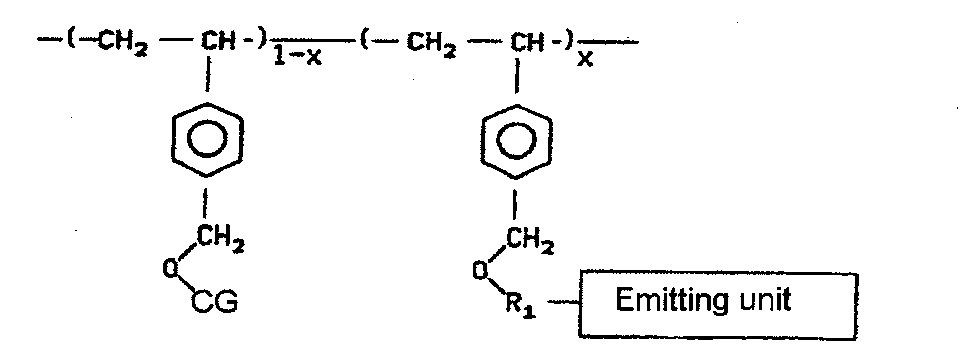 R₁ = - (CH₂)ₙ- with 2 ≤ n ≤ 10,
the emitting unit being of type 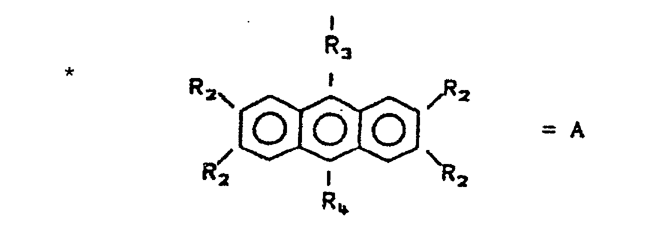 with R₂: -O-C_{q}H_{2q+1}; -OOC-C_{q}H_{2q+1} with 1 ≤ q ≤ 20 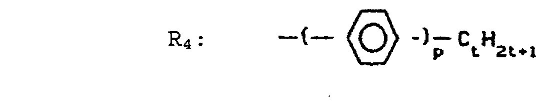 with p = 0 or 1
0 ≤ t ≤ 20 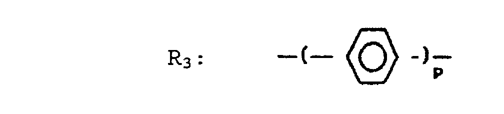 with p = 0 or 1
* or 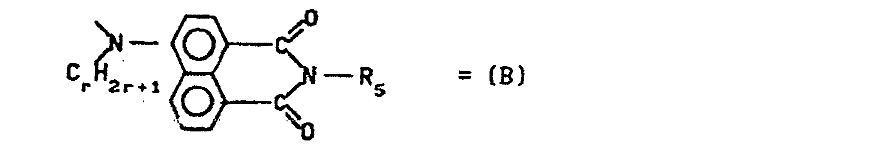 with 1 ≤ r ≤ 10
R₅: CₛH₂ₛ₊₁ with 1 ≤ s ≤ 10
or 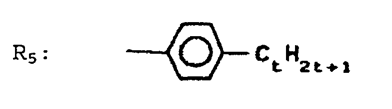 with 0 ≤ t ≤ 10 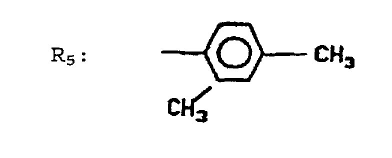 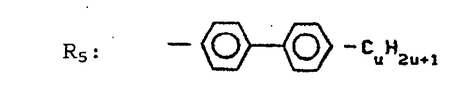 with 0 ≤ u ≤ 10
* or 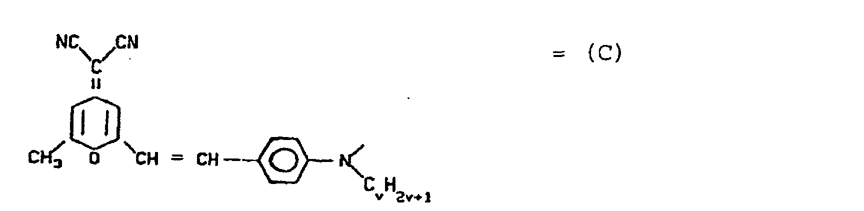 with 1 ≤ v ≤ 10
CG is a crosslinkable group of type 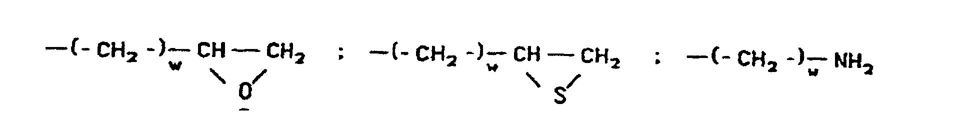 with 2 ≤ w ≤ 10 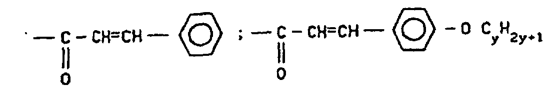 (with 1 ≤ y ≤ 10); 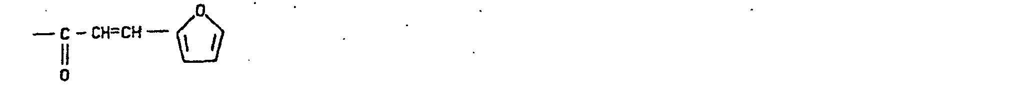 and **characterized in that** it additionally comprises molecules with an absorption spectrum which at least partially overlaps the electroluminescence spectrum of the electroluminescent polymer and with an emission spectrum which is situated within higher wavelengths than the said electroluminescence spectrum.

2. Electroluminescent material according to Claim 1, emitting in the green region, **characterized in that** the molecules are of type:

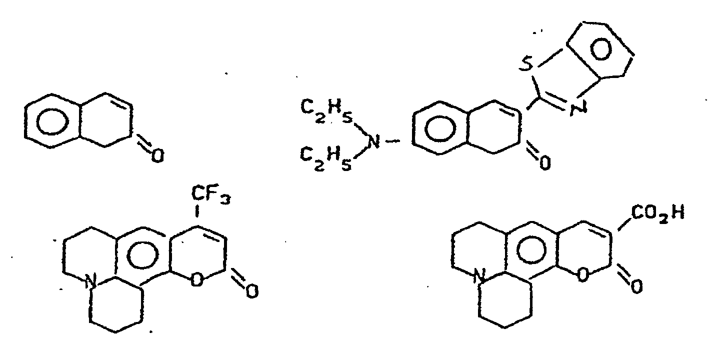

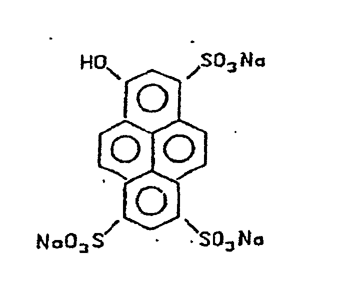

3. Electroluminescent material according to Claim 1, emitting in the red region, **characterized in that** the molecules are of type:

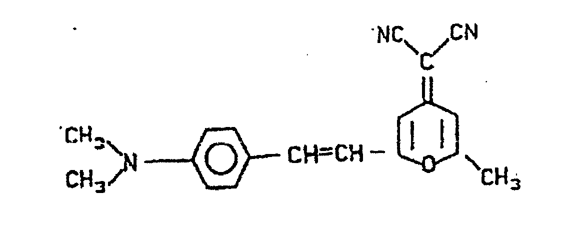

4. Electroluminescent diode comprising a substrate covered with an anode, a layer (C₁) providing the transportation of holes, a layer (C₂) comprising an electroluminescent material according to one of Claims 1 to 3, a layer (C₃) providing the transportation of electrons and a cathode.

5. Electroluminescent diode according to Claim 4, **characterized in that** the material of the layer (C₁) is of polyvinylcarbazole type or of the type of polymer derived from

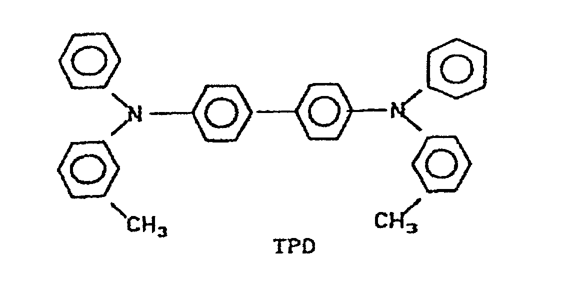

6. Electroluminescent diode according to either of Claims 4 and 5, **characterized in that** the material of the layer (C₃) is of the type

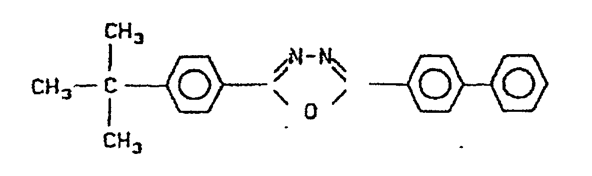

7. Process for the manufacture of an electroluminescent material according to Claim 1, characterized in that- it comprises the synthesis of poly[N-(4-butylphenyl)-4-(N-(4-vinylbenzyloxyethyl)-N-methylamino)]naphthalimide comprising the following stages:
- the synthesis of 4-(N-(2-hydroxyethyl)-N-methylamino)-N-(4-butylphenyl)naphthalimide;
- the synthesis of the monomer N-(4-butylphenyl)-4-(N-(4-vinylbenzyloxyethyl)-N-methylamino)-naphthalimide by reaction of 4-(N-(2-hydroxyethyl)-N-methylamino)-N-(4-butylphenyl)-naphthalimide in the presence of NaH, of petroleum ether 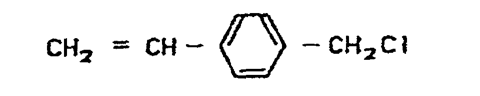
and of dimethylformamide (DMF);
- the polymerization of the monomer in the presence of toluene and of azobisisobutyronitrile (AIBN).
